# EUROPEAN PATENT SPECIFICATION

(11) **EP 0 919 640 B1**
(45) Date of publication and mention of the grant of the patent: **09.06.2004**
(21) Application number: 98122241.7
(22) Date of filing: 23.11.1998
(51) Int. Cl.: C23C 4/12

(54) **A method of manufacturing three dimensional parts using an inert gas**
Verfahren zur Herstellung von dreidimensionalen Teilen mit Inertgas
Procédé de fabrication de pièces tridimensionelles sous gaz inerte

(30) Priority: 25.11.1997 US 977819; 25.11.1997 US 977814
(43) Date of publication of application: 02.06.1999
(73) Proprietor: Xerox Corporation, Rochester, New York 14644 (US)
(72) Inventor: Horine, David A., Los Altos, CA 94024 (US)
(74) Representative: Grünecker, Kinkeldey, Stockmair & Schwanhäusser Anwaltssozietät

(56) References cited:
- EP-A- 0 682 988
- WO-A-97/09125
- US-A- 5 266 098
- US-A- 5 520 715

## Description

### Background

The present invention is directed to a method and apparatus for manufacturing three dimensional products. Some of the familiar prior art techniques for creating such products include, casting, extrusion, stereolithography and powder metallurgy. After the initial product is formed in the prior art, forming techniques, extractive techniques, chemical etching and additive or deposition techniques are often also performed to bring the product to final form.

Casting is usually performed by pouring a liquid, such as molten metal or plastic, into a mold and letting it cool and solidify. The metal takes the shape of the mold's interior surface as it solidifies. In extrusion semi-molten or molten plastic or hot metal is forced through an extrusion die which has a predetermined two dimensional shape. The extruded material takes the shape of the die and the shape of the die is transferred to the product through contact. In powdered metallurgy a batch of solid metal particles or powder is introduced into a mold where high temperature and pressure are applied to fuse or sinter the particles together. As is the case with casting, the end product assumes the shape of the mold's interior surface. In stereolithography an object is made by solidifying superposed layers of curable plastic resin until the complete object is built up.

After these initial objects are produced, forming techniques, extractive techniques, chemical etching, and additive or depositive techniques are often used to bring the product to the final form. Additional manufacturing techniques for making such objects include creating the products out of preformed component parts which are then joined by welding, soldering or brazing, or gluing.

However, many of these techniques have disadvantages. The molded form technique requires the mold be manufactured before the intended end product can be produced. In extractive techniques, much of the material is discarded causing waste of production materials. Metal fabrication by welding, soldering and brazing requires that the component parts be preformed before the final joining operation. In stereolithography individual layers may change their volume when solidifying causing stresses and deformation in the resultant product and materials are limited to a few plastic resins. In addition the specialized facilities needed for manufacturing are bulky and expensive.

A directional electrostatic accretion process employing acoustic droplet formation has been described in US Patent No. 5,520,715 by Oeftering, issued May 28, 1996 which addresses some of these issues. The process uses acoustically formed charged droplets of molten metal which are controlled by an acceleration electrode and deflection plates to build up a three dimensional product on a target substrate. The system is precisely controlled by a design workstation which has the parameters of the product to be built to insure the accuracy of the trajectory of each charged droplet. This process is certainly an improvement over prior processes because it requires less equipment that need not be retooled for every product desired to be reproduced, but it is limited in use because it must be operated in a vacuum or oxygen free atmosphere to eliminate the formation of an oxide skin on the free surface of the liquid metal. Formation of an oxide skin can impede ejection of metal droplets and absorb acoustic energy.

An oxygen free atmosphere can be created two ways, either operating in the vacuum of space or by enclosing the entire apparatus. Enclosing the apparatus requires additional large and complex machinery. Additionally, maintaining a precise depth of the pool of molten metal when the device is placed in a vacuum requires additional process steps not necessary when such a device is used in an atmospheric environment. Conventional displacement devices have been shown to be unreliable when used in a vacuum unoppsed by some external pressure means. Therefore the pool depth must be monitored and regulated using displacement means or an acoustic radiation pump.

It would therefore be desirable to build a manufacturing device, which requires fewer bulky parts, does not require retooling for each new part and which is capable of building three dimensional parts out of molten metal but which does not require the apparatus to be operated in a vacuum or an oxygen free atmosphere.

Further advantages of the invention will become apparent as the following description proceeds.

### Summary of the Invention

In order to solve one aspect of the object of the present invention, there is provided a device for emitting liquid metal droplets on demand from a free surface of a liquid pool according to claim 1.

In order to solve another aspect of the object of the present invention, there is provided a method for manufacturing metal structures according to claim 3, in which minute drops of a liquid metal are emitted from an acoustic device through an inert gas. The presence of the inert gas at the surface of the liquid metal prevent the formation of an oxide skin which would absorb acoustic energy and hinder droplet formation and emission. The droplets are then emitted towards a substrate, which may form as a carrier, where they may be used to form solder bumps, circuit traces, or accreted to form a three dimensional device.

### Brief Description of the Drawings

Figure 1 shows a cross sectional view of a device which generates liquid droplets using focussed acoustic energy according to the present invention.
Figure 2 shows a perspective view of a product made using the present invention.
While the present invention will be described in connection with a preferred embodiment and method of use, it will be understood that it is not intended to limit the invention to that embodiment and procedures. On the contrary, it is intended to cover all alternatives, modifications and equivalents as may be included within the spirit and scope of the invention as defined by the appended claims.

### Detailed Description of the Invention

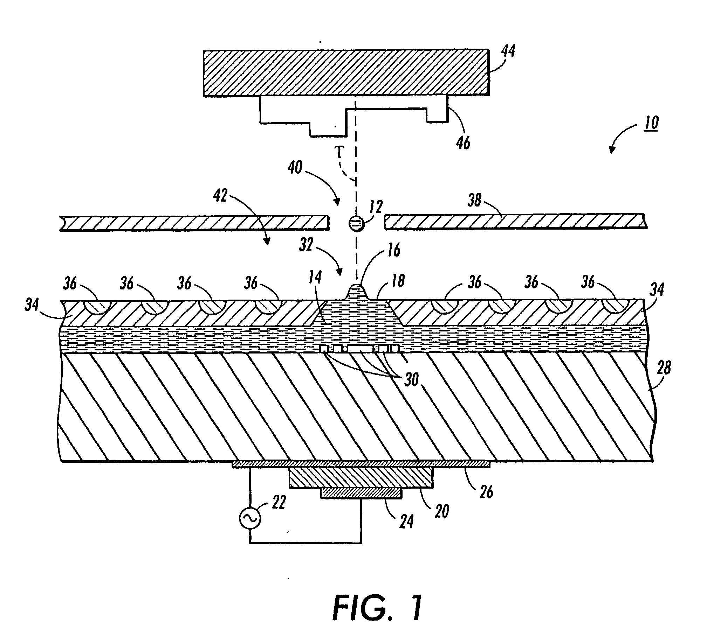

Turning now to figure 1 a device which generates liquid droplets using focussed acoustic energy is shown. Such devices are known in the art for use in printing applications. Detailed descriptions of acoustic droplet formation and acoustic printing can be found in the following disclosures: US Patent No. 4, 308,507; US Patent No 4,697,195, US Patent No 5,041,849; US Patent No 5,121,141 and US Patent No 5,608,433.

The most important feature of the device shown in figure 1 is that it does not use nozzles and is therefore unlikely to clog, especially when compared to other methods of forming and ejecting small, controlled droplets. The device can be manufactured using photolithographic techniques to provide groups of densely packed emitters each of which can eject carefully controlled droplets. Furthermore, it is known that such devices can eject a wide variety of materials, US Patent No. 5, 591, 490, describes a method for using an array of such acoustic droplet emitters to form a uniform layer of resist, US Patent No. 5,565,113, states that the principles of acoustic printing are suitable for ejection of materials other than marking fluids, such as mylar catalysts, molten solder, hot melt waxes, color filter materials, resists, chemical compounds, and biological compounds. US Patent No. 5,520,715 describes using focussed acoustic energy to emit droplets of liquid metal.

With the above concepts firmly in mind, the operation of an exemplary acoustic droplet emitter, according to the present invention, will now be described. There are many variations in acoustic droplet emitters and the description of a particular droplet emitter is not intended to limit the disclosure but to merely provide an example from which the principles of acoustic droplet generation in this inventions particular context can be understood.

Figure 1 shows an acoustic droplet emitter 10 shortly after emittion of a droplet 12 of a liquid metal 14 and before a mound 16 on a free surface 18 of the liquid metal 14 has relaxed. The forming of the mound 16 and the subsequent ejection of the droplet 12 is the result of pressure exerted by acoustic forces created by a ZnO transducer 20. To generate the acoustic pressure, RF energy is applied to the ZnO transducer 20 from an RF source via a bottom electrode 24 and a top electrode 26. The acoustic energy from the transducer 20 passes through a base 28 into an acoustic lens 30. The acoustic lens 30 focuses its received acoustic energy into a small focal area which is at or very near the free surface 18 of the liquid metal 14. Provided the energy of the acoustic beam is sufficient and properly focused relative to the free surface 18 of the liquid 14, a mound 16 is formed and a droplet 12 is subsequently emitted on a trajectory T.

The liquid metal 14 is contained by a top plate 34 which has a opening 32 in which the free surface 18 of the liquid 14 is present and from which the droplet 12 is emitted. The liquid 14 metal flows beneath the top fluid containment plate 34 and past the acoustic lens 30 without disturbing the free surface 18. Heaters 36 are provided in the top fluid containment plate to insure proper temperature control and liquidity of the liquid metal 14.

The opening 32, in the top fluid containment plate 34, is many times larger than the drop 12 which is emitted thereby greatly reducing clogging of the opening, especially as compared to other droplet ejection technologies. It is this feature of the droplet emitter 10 which makes its use desirable for emitting droplets of a wide variety of materials. Also important to the invention is the fact that droplet size of acoustically generated and emitted droplets can be precisely controlled. Drop diameters can be as small as 16 microns allowing for the deposition of very small amounts of material.

Also present in the droplet emitter 10 is a top gas containment plate 38 with an opening 40 which is aligned with the opening 32 in the top fluid containment plate 34. Opening 40 in the top gas containment plate 38 need not be as large as opening 32 in the top fluid containment plate. Opening 40 in the top gas containment plate 38 need only be large enough for the emitted droplet 12 to pass through unobstructed. A continuously flowing inert gas 42 flows through the space created between the top fluid containment plate 34 and the top gas containment plate 38. The inert gas 42 needs only to flow with some positive pressure. It is desirable to keep the flow rate as low as possible to avoid disturbing the trajectory T of the emitted droplet 12 at approximately 4m/sec. Flow rates of approximately 0.5 m/sec or less should be sufficient to provide a continuous flow of inert gas 42 without disturbing the trajectory T of the emitted droplet 12. By inert gas, what is meant is a gas that will not react with the free surface 18 of the liquid metal 14. Examples of such gasses include argon, zenon, krypton or nitrogen, although any such gas is appropriate. If the inert gas 42 were not present, then oxygen in the atmosphere would react with the free surface 18 of the liquid to form an oxide skin which would absorb acoustic energy and impede the emission of droplets 12 from the droplet emitter 10. The mound 16 and the droplet 12 are formed in the presence of the inert gas 42. The droplet 12 is then emitted through the opening 40 in the top gas containment plate 38 along the trajectory T towards the substrate 44, forming a solid structure 46 on the substrate 44.

It should be noted that the inert gas 42 will bleed slightly. through the opening 40 in the top gas containment plate 42. If the substrate 44 is placed in close proximity to the droplet emitter 10, then the gap between the substrate 44 and the droplet emitter 10 should be at least partially filled with inert gas 42 due to the bleeding of the inert gas 42 though the opening 40 in the top gas containment plate 38. The maximum recommended distance between the droplet emitter 10 and the substrate 44 or the surface of the solid structure 46 is approximately 1 mm.

The solid structure 46 is built up in three dimensions by emitting successive layers of droplets 12. This can be accomplished by either moving the substrate 44 while maintaining droplet emitter 10 as fixed, moving droplet emitter 10 while maintaining the substrate 44 as fixed or moving both substrate 44 and droplet emitter 10. As the layers build up to form solid structure 46, it may be necessary to adjust the positioning of the substrate 44 to provide more distance between the substrate 44 and the droplet emitter 10. This is to compensate for build-up of solid structure 46 and maintain a preferred distance between the droplet emitter 10 and either substrate 44 or solid structure 46. Again this can be accomplished by either moving the substrate 44 while maintaining droplet emitter 10 as fixed, moving droplet emitter 10 while maintaining the substrate 44 as fixed or moving both substrate 44 and droplet emitter 10.

While a variety of liquified metals might be used, one example particularly suited for this process is any of the varieties of solder. For example, a solder made up of 63% tin and 37% lead has a melting point of only 183 degrees centigrade. The low melting points of solders makes them especially suited for this type of application.

In practice, the individual droplet emission of liquid metals can be used in various applications. Shown in Figure 1, is the application of building three dimensional metal structures. The structure can either be formed from the desired metal needed for a particular part or formed from a metal that has a low melting point, such as the solders mentioned above, and used as an investment casting for high melting point alloys. The advantage to making investment castings from this process is that investment castings with very fine details can be made due to the small droplet size, about 16 microns in diameter, obtainable with this process.

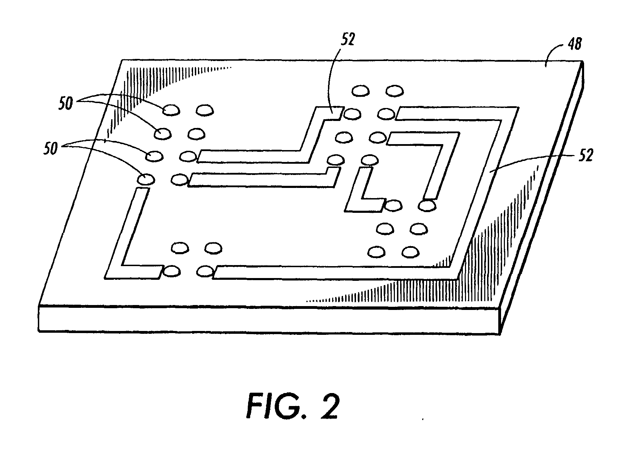

An alternative product is shown in Figure 2. Figure 2 is a perspective view of a circuit board or electronic part 48 which has a plurality of solder bumps 50. Solder bumps are often used as a means of joining integrated circuits to substrates. The droplet emitter 10 shown in Figure 1 has the unique ability to consistently and reliably deliver measured droplets to a particular destination making it especially suitable to manufacture solder bumps. Either a single droplet 12 or a small multiple number of droplets 12 can be emitted to a particular location to form a solder bump as shown in Figure 2.

Also shown in Figure 2 are metal interconnect lines 52. Again because of the ability of droplet emitter 10 to deliver measured droplets in a variety of conceivable patterns, droplet emitter 10 is especially suited for this type of manufacturing.

## Claims

1. A device for emitting liquid metal droplets on demand from a free surface of a liquid pool comprising:
a) a solid substrate having first and second surfaces, and having an acoustic focussing element on the first surface,
b) acoustic wave generating means intimately coupled to the second surface of said solid substrate for generating rf acoustic waves such that the acoustic focussing element causes an acoustic beam to be focussed to converge near the free surface of the liquid pool, for forming droplets of the liquid,
c) a top fluid control plate, having first and second surfaces, with the first surface in intimate contact with the liquid pool, said top fluid control plate have at least one opening therethrough, the opening being aligned with said acoustic wave generating means and the acoustic focussing element such that the acoustic beam focussed near the free surface of the pool will be focussed at least partly within the opening, the opening being large enough to permit droplets formed by the focussing of the acoustic beam at the free surface of the liquid to pass therethrough,
d) a top gas containment plate have first and second surfaces to at least partially contain an inert gas between the first surface of the top gas containment plate and the second surface of the top fluid control plate, said top gas containment plate having at least one opening therethrough, the opening in the top gas containment plate being aligned with the opening in the top fluid control plate such that any liquid drops passing through the opening in the top fluid control plate may also pass through the top gas containment plate.

2. The device for emitting liquid metal droplets on demand from a free surface of a liquid pool of Claim 1 wherein the opening in the top gas containment plate is approximately one-half the size of the opening of the opening in the top fluid control plate.

3. A method for forming liquid metal droplets comprising the steps of:
a) providing a pool of a molten metal with a free surface,
b) providing means for a controlled continual flow of an inert gas across the free surface of the pool of molten metal according to claim 1 or 2,
c) generating ultrasonic acoustic waves with at least one ultrasonic transducer adjacent to the pool of molten metal,
d) focusing the generated ultrasonic acoustic waves to converge near the free surface of the pool of molten metal to emit drops of liquid metal through the continual flow of inert gas using at least one acoustic lens positioned adjacent to the at least one ultrasonic transducer.

4. The method for forming liquid metal droplets of Claim 3 further comprising the step of successively depositing the emitted droplets of liquid metal onto a substrate to form a solid structure.

5. The method for forming liquid metal droplets of Claim 3 wherein the continual flow of inert gas is at approximately 0.5m/sec or less.

6. The method for forming liquid metal droplets of Claim 4 wherein the continual flow of inert gas across the free surface also comprises bleeding gas outward from the free surface.

7. The method for forming liquid metal droplets of Claim 6 wherein the space between the free surface and the substrate are substantially filled with the inert gas.

## Patentansprüche

1. Vorrichtung zum Emittieren flüssiger Metalltröpfchen auf Anforderung von einer freien Oberfläche eines Flüssigkeitsbades, die umfasst:
a) ein massives Substrat mit einer ersten und einer zweiten Fläche, das ein Schall-Fokussierelement auf der ersten Fläche aufweist,
b) eine Schallwellen-Erzeugungseinrichtung, die eng mit der zweiten Fläche des massiven Substrats verbunden ist, um HF-Schallwellen zu erzeugen, so dass das Schall-Fokussierelement bewirkt, dass ein Schallstrahl so fokussiert wird, dass er in der Nähe der freien Oberfläche des Flüssigkeitsbades konvergiert, um Tröpfchen der Flüssigkeit auszubilden,
c) eine obere Fluid-Steuerplatte mit einer ersten und einer zweiten Fläche, wobei die erste Fläche in engem Kontakt mit dem Flüssigkeitsbad ist, die obere Fluid-Steuerplatte wenigstens eine Öffnung hat und die Öffnung so auf die Schallweiten-Erzeugungseinrichtung und das Schall-Fokussierelement ausgerichtet ist, dass der Schallstrahl, der in der Nähe der freien Oberfläche des Bades fokussiert wird, wenigstens teilweise in der Öffnung fokussiert wird, wobei die Öffnung groß genug ist, um Tröpfchen hindurchtreten zu lassen, die durch das Fokussieren des Schallstrahls an der freien Oberfläche der Flüssigkeit ausgebildet werden,
d) eine obere Gas-Einschlussplatte mit einer ersten und einer zweiten Fläche, die ein inertes Gas wenigstens teilweise zwischen der ersten Fläche der oberen Gas-Einschlussplatte und der zweiten Fläche der oberen Fluid-Steuerplatte einschließt, wobei die obere Gas-Einschlussplatte wenigstens eine Öffnung aufweist und die Öffnung in der oberen Gas-Einschlussplatte so auf die Öffnung in der oberen Fluid-Steuerplatte ausgerichtet ist, dass alle Flüssigkeitströpfchen, die durch die Öffnung in der oberen Fluid-Steuerplatte hindurchtreten, auch durch die obere Gas-Einschlussplatte hindurchtreten können.

2. Vorrichtung zum Emittieren von flüssigen Metalltröpfchen auf Anforderung von einer freien Oberfläche eines Flüssigkeitsbades nach Anspruch 1, wobei die Öffnung in der oberen Gas-Einschlussplatte ungefähr halb so groß ist wie die Öffnung in der oberen Fluid-Steuerplatte.

3. Verfahren zum Ausbilden flüssiger Metalltröpfchen, das die folgenden Schritte umfasst:
a) Bereitstellen eines Bades aus geschmolzenem Metall mit einer freien Oberfläche,
b) Bereitstellen einer Einrichtung für einen gesteuerten kontinuierlichen Strom eines inerten Gases über die freie Oberfläche des Bades aus geschmolzenem Metall nach Anspruch 1 oder 2,
c) Erzeugen von Ultraschallwellen mit wenigstens einem Ultraschallwandler an das Bad aus geschmolzenem Metall angrenzend,
d) Fokussieren der erzeugten Ultraschallwellen, so dass sie in der Nähe der freien Oberfläche des Bades aus geschmolzenem Metall konvergieren, um Tröpfchen aus flüssigem Metall durch den kontinuierlichen Strom von inertem Gas zu emittieren, unter Verwendung wenigstens einer Schall-Linse, die an den wenigstens einen Ultraschallwandler angrenzend angeordnet ist.

4. Verfahren zum Ausbilden flüssiger Metalltröpfchen nach Anspruch 3, das des Weiteren den Schritt des aufeinander folgenden Abscheidens der emittierten Tröpfchen aus flüssigem Metall auf ein Substrat zum Ausbilden einer massiven Struktur umfasst.

5. Verfahren zum Ausbilden flüssiger Metalltröpfchen nach Anspruch 3, wobei der kontinuierliche Strom von inertem Gas ungefähr 0,5 m/s oder weniger beträgt.

6. Verfahren zum Ausbilden flüssiger Metalltröpfchen nach Anspruch 4, wobei der kontinuierliche Strom von inertem Gas über die freie Oberfläche auch das Ablassen von Gas von der freien Oberfläche nach außen umfasst.

7. Verfahren zum Ausbilden flüssiger Metalltröpfchen nach Anspruch 6, wobei der Raum zwischen der freien Oberfläche und dem Substrat im Wesentlichem mit dem inerten Gas gefüllt ist.

## Revendications

1. Dispositif pour émettre des gouttelettes de métal liquide à la demande à partir d'une surface libre d'une flaque de liquide comprenant :
a) un substrat solide ayant une première et une deuxième surfaces, et ayant un élément de focalisation acoustique sur la première surface,
b) un moyen pour générer une onde acoustique couplé de façon étroite à la deuxième surface dudit substrat solide pour générer des ondes acoustiques rf de telle façon que l'élément de focalisation acoustique provoque un faisceau acoustique focalisé pour converger près de la surface libre de la flaque de liquide, pour former des gouttelettes du liquide.
c) plateau de contrôle de fluide supérieur, ayant une première et une deuxième surfaces, avec la première surface en contact étroit avec la flaque de liquide, ledit plateau de contrôle de liquide supérieur a au moins une ouverture à travers, l'ouverture étant alignée avec ledit moyen de génération d'onde acoustique et l'élément de focalisation acoustique de façon que le faisceau acoustique focalisé près de la surface libre de la flaque soit dirigé au moins partiellement dans l'ouverture, l'ouverture étant suffisamment grande pour permettre aux gouttes formées par la focalisation du faisceau acoustique sur la surface libre du liquide de passer à travers.
d) un plateau de confinement de gaz de gueulard ayant une première et une deuxième surface pour contenir au moins partiellement un gaz inerte entre la première surface du plateau de confinement du gaz de gueulard et la deuxième surface du plateau de contrôle de fluide supérieur, ledit plateau de confinement de gaz de gueulard ayant au moins une ouverture à travers, l'ouverture dans le plateau de confinement de gaz de gueulard étant alignée avec l'ouverture dans le plateau de contrôle de fluide supérieur de telle façon que toutes les gouttes de liquide passant à travers l'ouverture dans le plateau de contrôle de fluide supérieur puisse aussi passer à travers le plateau de confinement de gaz de gueulard.

2. Dispositif pour émettre des gouttelettes de métal liquide à la demande à partir d'une surface libre d'une flaque de liquide selon la revendication 1 dans lequel l'ouverture dans le plateau de confinement de gaz de gueulard est approximativement la moitié de la taille de l'ouverture de l'ouverture dans le plateau de contrôle de fluide supérieur.

3. Procédé pour former des gouttelettes de métal liquide comprenant les étapes de :
a) fourniture d'une flaque d'un métal fondu avec une surface libre,
b) fourniture d'un moyen pour un écoulement continuel et contrôlé d'un gaz inerte à travers la surface libre de la flaque de métal fondu selon la revendication 1 ou 2.
c) génération d'ondes acoustiques ultrasoniques avec au moins un transducteur ultrasonique adjacent à la flaque de métal fondu,
d) focalisation des ondes acoustiques ultrasoniques générées pour qu'elles convergent près de la surface libre de la flaque de métal fondu pour émettre des gouttes de métal liquide à travers l'écoulement continu de gaz inerte en utilisant au moins une lentille acoustique placée de façon adjacente au au moins un transducteur ultrasonique.

4. Procédé pour former des gouttelettes de métal liquide selon la revendication 3 comprenant de plus l'étape de déposition successive des gouttelettes émises de métal liquide sur un substrat pour former une structure solide.

5. Procédé pour former des gouttelettes de métal liquide selon la revendication 3 dans lequel l'écoulement continu de gaz inerte est de 0,5m/seconde approximativement ou inférieur.

6. Procédé pour la formation de gouttelettes de métal liquide selon la revendication 4 dans lequel l'écoulement continu de gaz inerte à travers la surface libre comprend aussi un gaz s'écoulant vers l'extérieur à partir de la surface libre.

7. Procédé pour la formation de gouttelettes de métal liquide selon la revendication 6 dans lequel l'espace entre la surface libre et le substrat est sensiblement rempli avec le gaz inerte.
